# FASCICULE DE BREVET EUROPEEN

(11) **EP 0 506 501 B1**
(45) Date de publication et mention de la délivrance du brevet: **15.05.1996**
(21) Numéro de dépôt: 92400618.2
(22) Date de dépôt: 10.03.1992
(51) Int. Cl.: H03L 7/085, H03L 7/081, H03D 13/00, G01R 25/04

(54) **Dispositif comparateur de phase à grande dynamique**
Phasenkomparator mit grossem Dynamikbereich
Phase-comparator with wide dynamic range

(30) Priorité: 22.03.1991 FR 9103501
(43) Date de publication de la demande: 30.09.1992
(73) Titulaire: THOMSON-CSF, F-75008 Paris (FR)
(72) Inventeur: Marcuard, Alain, F-92045 Paris la Défense (FR)
(74) Mandataire: Lincot, Georges

(56) Documents cités:
- EP-A- 0 240 232
- EP-A- 0 256 637
- US-A- 4 728 884
- INTERNATIONAL JOURNAL OF ELECTRONICS vol. 49, no. 4, octobre 1980, pages 333-337, London, GB; M. EMURA et al.: "Wide dynamic range phase-comparator using an analogue shift register"
- PATENT ABSTRACTS OF JAPAN vol. 11, no. 374 (E-562)(2821), 5 décembre 1987; & JP - A - 62142429 (SONY) 25.06.1987

## Description

La présente invention concerne un dispositif comparateur de phase à grande dynamique utilisable dans une boucle à asservissement de phase.

Elle s'applique notamment à la réalisation de boucles de calcul de delta pseudo-distances dans les récepteurs de radionavigation par satellite GPS.

Une boucle à asservissement de phase se compose classiquement de trois éléments formés par un oscillateur local à fréquence variable encore connu sous les abréviations VCO ou NCO, un comparateur de phase pour discriminer l'écart de phase existant entre le signal fourni par l'oscillateur local et un signal incident, un amplificateur et un filtre de boucle commandant la fréquence de l'oscillateur local à partir de l'écart de phase fourni par le comparateur de phase.

Avec une telle boucle, la fréquence de l'oscillateur n'est plus efficacement contrôlée soit du fait que le niveau du signal incident diminue, quand le rapport signal à bruit est trop faible dans la bande passante définie par le filtre de boucle, soit que la dynamique de phase du comparateur de phase, c'est à dire son aptitude à fournir un signal valide lorsque la différence de phase entre le signal de référence et le signal incident est importante, est dépassée par les excursions de phases du signal.

Dans ces conditions, pour obtenir des mesures de bonne qualité sur un signal incident bruité ou de faible valeur il y a lieu de diminuer la bande passante de la boucle d'asservissement de phase. Ceci est réalisé en augmentant la constante de temps de filtrage, mais alors le traînage de la boucle aux variations de phase entre le signal incident et le signal de référence est augmenté et il faut pour éviter un décrochage de la boucle que le comparateur de phase puisse accepter de travailler sur des écarts de phase importants.

Cependant les comparateurs de phase connus des types OU exclusif, tangente, cotangente limitent à quelques radians l'écart de phase entre le signal incident et le signal de référence. Cela conduit pour des excursions plus importantes à employer des comparateurs de fonctions de transfert non linéaires ce qui complique beaucoup la réalisation du dispositif, et fait perdre en général l'information de différence de phase pendant un temps limité. Il est également connu du brevet US 4 728 884 un circuit détecteur de phase à grande dynamique utilisant un circuit accumulateur d'erreur de phase entre un signal de référence et un signal de test 2. Mais le signal cumulé qui est obtenu présente des discontinuités qui ne sont pas tolérables pour la réalisation de boucles à asservissement de phase.

Le but de l'invention est de pallier les inconvénients précités.

A cet effet, l'invention a pour objet un dispositif comparateur de phase à grande dynamique comportant un comparateur de phase dont la caractéristique de transfert est linéaire pour mesurer sur une plage de phase déterminée l'écart de phase existant entre un signal incident et un signal de référence local fourni par un générateur de signal à phase contrôlé caractérisé en ce qu'il comprend d'une part, un circuit d'accumulation de phase couplé à la sortie du comparateur de phase par l'intermédiaire d'un circuit échantillonneur-bloqueur de l'écart de phase mesuré par le comparateur de phase avant de l'appliquer sur le circuit accumulateur de phase pour accumuler successivement à des instants déterminés les écarts de phase mesurés par le comparateur de phase et commander le générateur de signal à phase contrôlée pour que sa phase suive en permanence la somme de la phase du signal de référence externe et de la valeur des écarts de phase cumulés dans le circuit d'accumulation et d'autre part, un circuit additionneur couplé à la sortie du circuit d'accumulation de phase et à la sortie du comparateur pour additionner au contenu du circuit d'accumulation l'écart de phase mesuré par le comparateur de phase.

Le dispositif comparateur de phase selon l'invention a pour avantage qu'il permet d'obtenir une dynamique de phase qui peut être étendue à volonté et dont la caractéristique de transfert monotone parfaitement linéaire simplifie le calcul des boucles à asservissement de phase et permet de ne jamais perdre l'information de différence de phase dans la boucle.

D'autres caractéristiques et avantages de l'invention apparaîtront ci-après à l'aide de la description qui suit faite en regard des dessins annexés qui représentent :
- La figure 1 un mode de réalisation d'un dispositif comparateur de phase selon l'invention.
- La figure 2 un graphe montrant l'évolution en fonction du temps de signaux a(t), b(t) et M(t) caractéristiques du mode de réalisation de la figure 1.

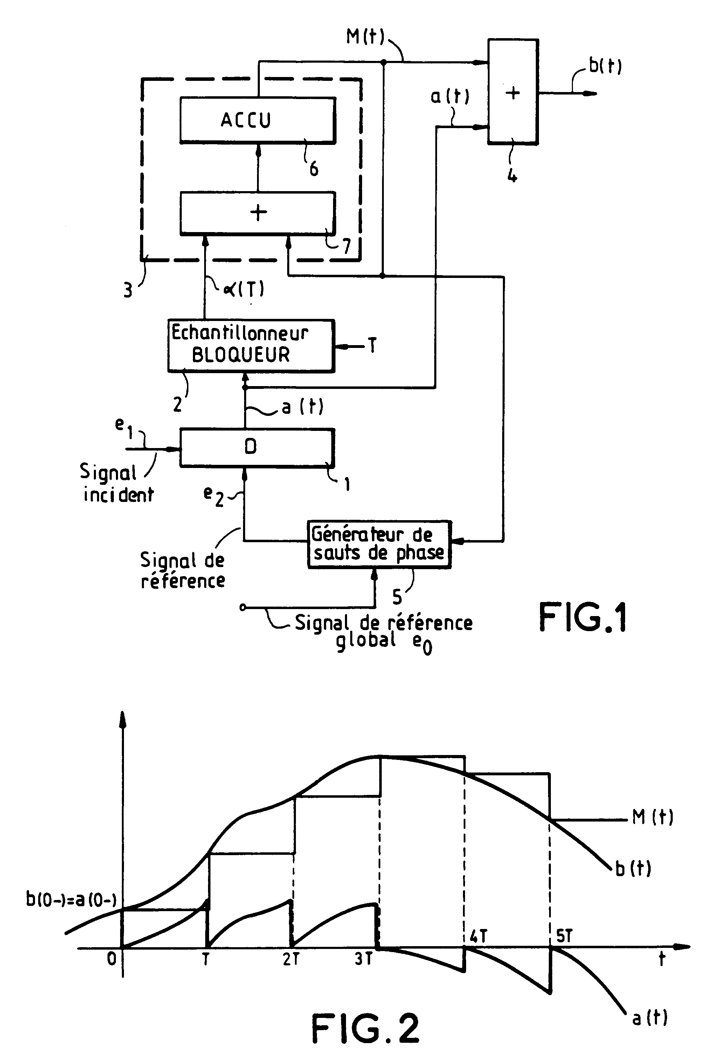

Le dispositif comparateur de phase selon l'invention qui est représenté à la figure 1 comporte un comparateur de phase 1, couplé par l'intermédiaire d'un circuit échantillonneur bloqueur 2 à un circuit d'accumulation de phase 3 représenté à l'intérieur d'une ligne fermée en pointillés. Il comprend également un circuit additionneur 4 à deux entrées d'opérandes reliées respectivement à la sortie du circuit d'accumulation 3 et à la sortie du comparateur de phase 1, ainsi qu'un générateur de sauts de phase commandé par la sortie du circuit d'accumulation 3 transformant le signal e₀ de référence global, en un signal e₂ de référence local.

Le comparateur de phase 1 peut être formé par tout type de circuit "OU exclusif" classique, capable de mesurer linéairement une différence de phase entre deux entrées écrêtées e₁ et e₂, comprise par exemple entre + et - 45 degrés. L'entrée e₁ reçoit le signal incident et l'entrée e₂ du comparateur de phase 1 reçoit le signal de référence global corrigé par les écarts de phase ou sauts de phase fournis par une sortie du générateur 5.

Le circuit d'accumulation 3 comporte de façon connue un registre accumulateur 6 rebouclé sur son entrée par l'intermédiaire d'une première entrée d'opérande d'un circuit additionneur 7, la deuxième entrée d'opérande du circuit additionneur 7 étant reliée à la sortie du circuit échantillonneur bloqueur 2.

Le circuit d'accumulation 3 joint au circuit additionneur 4 et au générateur de saut de phase 5 permet à l'ensemble du dispositif de fournir un écart de phase continûment variable indépendamment de la dynamique de phase plus ou moins réduite du circuit comparateur 1.

En effet, en programmant le générateur 5 de façon que la phase obtenue à sa sortie soit égale à la phase mémorisée dans le registre accumulateur 6, il suffit de charger dans le registre accumulateur 6 à un instant d'initialisation t=t₀ l'écart de phase a₀ existant entre les deux entrées e₁ et e₂ du comparateur de phase 1 pour annuler l'écart de phase entre les entrées e₁ et e₂ du comparateur 1.

A un instant t₀+T plus tard l'écart de phase a₀ devient a(T). Cette valeur a(T) est alors échantillonnée comme le montre la figure 2 par l'échantillonneur bloqueur 2, pour être ensuite appliquée sur la première entrée d'opérande du circuit additionneur 7. Au contenu M du registre accumulateur 6 est alors ajouté la valeur a(T). La quantité M=M+a(T) ainsi obtenue est appliqué à l'entrée du générateur 5 et l'écart de phase a(T) qui lui correspond est à son tour appliqué sur la deuxième entrée e₂ d'opérande du circuit comparateur 1. Ceci a pour conséquence une remise à zéro du signal a(t) obtenu à la sortie du circuit comparateur 1. Pendant ce temps la sortie du circuit additionneur 4 fournit un signal b ( t ) =M+a ( t ) représentant l'addition de l'écart a(t) au contenu M du registre 6. L'avantage est que cette dernière opération ne fait pas apparaître de discontinuité sur la variable b(t) car si l'écart de phase a(T) à la sortie du circuit comparateur 1 passe de la valeur a(t) à la valeur 0 le contenu du registre accumulateur 6 passe de M(T) à M(T)+a(T). Ainsi bien que la variable a(t) soit discontinue, la variable représentant l'écart de phase b(t) obtenu à la sortie du circuit additionneur 4 apparaît toujours continue.

Naturellement les calculs précédents peuvent être recommencés à chaque nouvelle période de temps T. Le but de ces opérations est évidemment de limiter l'excursion de phase pendant la durée T entre les entrées e₁ et e₂ du comparateur 1 à une valeur compatible avec sa dynamique réelle et toute la valeur de T répondant à cette condition peut convenir. Par conséquent, lors de la construction par exemple d'une boucle à verrouillage de phase la période T devra être choisie en fonction des caractéristiques du filtre de la boucle de phase pour que l'évolution de la différence de phase incidente et de la phase de référence ne dépasse pas 45° en module pendant chaque intervalle d'observation T. On peut aussi penser à commander automatiquement l'échantillonneur bloqueur lorsque la valeur de a(t) atteint une limite préétablie, ce qui économise l'horloge externe de période T. En général, la durée de T pourra être choisie très faible devant les constantes de temps de filtrage, pour ne faire intervenir que les caractéristiques de dynamique de phase du signal incident.

La dynamique du dispositif comparateur de phase qui vient d'être décrit n'est limitée que par la capacité de mémorisation du registre accumulateur 6 et des possibilités de l'additionneur 4. Cependant, il est très facile de déterminer la taille de ces deux éléments avec un nombre de bits tel que la dynamique du comparateur puisse atteindre plusieurs dizaines de milliers de tours, de sorte qu'en pratique il n'y ait plus à considérer de limitation dynamique en phase due au comparateur de phase.

Naturellement, dans le cas où il faut préserver l'information d'amplitude du signal incident à travers le dispositif comparateur de phase selon l'invention, à la manière de ce qui est réalisé par exemple dans une boucle de Costas, une détection l'amplitude du signal incident sur la première entrée d'opérande du comparateur de phase 1 peut être effectuée avant de former par écrêtage le signal incident e₁ ; l'information d'amplitude peut alors être fournie en modulant par l'angle de phase b(t) obtenu à la sortie du circuit additionneur, l'information d'amplitude détectée, car alors l'information fournie au circuit accumulateur 3 et au circuit additionneur 4 ne représente que la phase du signal et non pas son amplitude.

## Revendications

1. Dispositif comparateur de phase à grande dynamique pour boucle à verrouillage de phase comportant un comparateur de phase (1) pour mesurer sur une plage de phase déterminée l'écart de phase a(t) existant entre un signal incident et un signal de référence fourni par un générateur de signal à phase contrôlé (5), caractérisé en ce qu'il comprend d'une part, un circuit d'accumulation de phase (3) couplé à la sortie du comparateur de phase (1) par l'intermédiaire d'un circuit échantillonneur-bloqueur (2) de l'écart de phase mesuré par le comparateur de phase (1) avant de l'appliquer sur le circuit accumulateur de phase (3) pour accumuler successivement à des instants déterminés les écarts de phase a(t) mesurés par le comparateur de phase (1) et commander le générateur de signal à phase contrôlée (5) pour que sa phase suive en permanence la valeur des écarts de phase cumulés dans le circuit d'accumulation (3) et d'autre part, un circuit additionneur (4) couplé à la sortie du circuit d'accumulation de phase (3) et à la sortie du comparateur (1) pour additionneur au contenu du circuit d'accumulation l'écart de phase a(t) mesuré par le comparateur de phase (1).

2. Dispositif selon la revendication 1 caractérisé en ce que le circuit d'accumulation de phase (3) comprend un registre accumulateur (6) chargé par la sortie d'un circuit additionneur (7) à deux entrées d'opérandes la première entrée d'opérande étant reliée à la sortie du registre accumulateur (6) et la deuxième entrée d'opérande étant reliée à la sortie du circuit échantillonneur bloqueur (2).

3. Dispositif selon l'une quelconque des revendications 1 et 2 caractérisé en ce que le circuit d'échantillonnage blocage (2) est commandé soit par une horloge externe de période fixe T, soit par un dispositif vérifiant que la valeur a(t) ne dépasse pas en module une limite aₒ définie par la dynamique propre du comparateur (1).

## Patentansprüche

1. Phasenkomparatoranordnung mit großem Dynamikbereich für einen PLL-Phasenregelkreis mit einem Phasenkomparator (1) zur Messung des zwischen einem ankommenden Signal und einem von einem Signalgenerator (5) mit gesteuerter Phase gelieferten Referenzsignal bestehenden Phasenabstands a(t) in einem bestimmten Phasenbereich, dadurch gekennzeichnet, daß sie einerseits eine Phasensummierschaltung (3) enthält, die mit dem Ausgang des Phasenkomparators (1) über eine Abtast- und Halteschaltung (2) zum Abtasten und Halten des vom Phasenkomparator (1) gemessenen Phasenabstands, bevor dieser der Phasensummierschaltung (3) zugeführt wird, verbunden ist, um in bestimmten Zeitpunkten nacheinander die vom Phasenkomparator (1) gemessenen Phasenabstände a(t) zu summieren und den Signalgenerator (5) mit gesteuerter Phase derart zu steuern, daß seine Phase dauernd dem Wert der in der Phasensummierschaltung (3) summierten Phasenabstände folgt, und andererseits eine Addierschaltung (4), die an den Ausgang der Phasensummierschaltung (3) und an den Ausgang des Komparators (1) angeschlossen ist, um den vom Phasenkomparator (1) gemessenen Phasenabstand a(t) zum Inhalt der Summierschaltung zu addieren.

2. Anordnung nach Anspruch 1, dadurch gekennzeichnet, daß die Phasensummierschaltung (3) ein Akkumulatorregister (6) enthält, das vom Ausgang einer Addierschaltung (7) mit zwei Operandeneingängen beschickt wird, wobei der erste Operandeneingang mit dem Ausgang des Akkumulatorregisters (6) verbunden ist und der zweite Operandeneingang mit dem Ausgang der Abtast- und Halteschaltung (2) verbunden ist.

3. Anordnung nach einem der Ansprüche 1 und 2, dadurch gekennzeichnet, daß die Abtast- und Halteschaltung (2) entweder durch einen äußeren Taktgeber mit fester Periode T oder durch eine Anordnung gesteuert wird, die verifiziert, daß der Wert a(t) dem Betrag nach nicht einen Grenzwert aₒ übersteigt, der durch die Eigendynamik des Komparators (1) definiert ist.

## Claims

1. Phase comparator device with wide dynamic range for a phase lock loop comprising a phase comparator (1) to carry out the measurement, over a determined phase range, of the phase difference a(t) existing between an incident signal and a reference signal given by a controlled-phase signal generator (5), characterized in that it comprises, firstly, a phase accumulation circuit (3) coupled to the output of the phase comparator (1) by way of a circuit (2) for sampling and holding the phase difference measured by the phase comparator (1) before applying it to the phase accumulation circuit (3) in order to accumulate, successively at determined instants, the phase differences a(t) measured by the phase comparator (1) and in order to operate the controlled-phase signal generator (5) so that its phase continuously follows the value of the phase differences accumulated in the accumulation circuit (3) and, secondly, an adder circuit (4) coupled to the output of the phase accumulation circuit (3) and to the output of the comparator (1) in order to add the phase difference a(t) measured by the phase comparator (1) to the contents of the accumulation circuit.

2. Device according to Claim 1, characterized in that the phase accumulation circuit (3) includes an accumulator register (6) loaded by the output of an adder circuit (7) with two operand inputs, the first operand input being connected to the output of the accumulator register (6) and the second operand input being connected to the output of the sample-and-hold circuit (2).

3. A device according to either of Claims 1 and 2 characterized in that the sample-and-hold circuit (2) is controlled either by an external clock with a fixed period T or by a device ascertaining that the value a(t) does not exceed, in modulus, a limit aₒ defined by the characteristic dynamic range of the comparator (1).
